# EUROPEAN PATENT SPECIFICATION

(11) **EP 2 311 065 B1**
(45) Date of publication and mention of the grant of the patent: **10.09.2014**
(21) Application number: 09775738.9
(22) Date of filing: 07.07.2009
(51) Int. Cl.: H01J 37/32, C23C 16/44

(54) **REMOTE PLASMA CLEANING METHOD AND APPARATUS FOR APPLYING SAID METHOD**
REMOTE-PLASMAREINIGUNGSVERFAHREN UND VORRICHTUNG ZUR ANWENDUNG DIESES VERFAHRENS
PROCÉDÉ DE NETTOYAGE PAR PLASMA À DISTANCE ET APPAREIL D'APPLICATION DUDIT PROCÉDÉ

(30) Priority: 09.07.2008 US 79286
(43) Date of publication of application: 20.04.2011
(73) Proprietor: TEL Solar AG, 9477 Trübbach (CH)
(72) Inventor: LEU, Felix-George, CH-9470 Buchs (CH); ELLERT, Christoph, CH-8880 Walenstadt (CH); BÜCHEL, Gerold, FL-9491 Ruggel (LI); MARTIN, Javier, A-6842 Koblach (AT)
(74) Representative: Liesegang, Eva
(86) International application number: PCT/CH2009/000239
(87) International publication number: WO 2010/003266

(56) References cited:
- EP-A- 1 489 646
- EP-A- 1 489 651
- WO-A-2007/027350
- WO-A-2007/045110
- US-A1- 2004 011 380
- US-A1- 2005 082 001

## Description

### FIELD OF THE INVENTION

This invention generally relates to methods and apparatuses suitable for removing residuals or un-wanted deposits within processing chambers, as being used e. g. in vacuum processing or treatment systems. More particularly, the invention relates to a method for cleaning the interior of a process chamber from silicon and/or silicon comprising components.

### BACKGROUND OF THE INVENTION

In industrial manufacturing of semiconductor devices systems for deposition of layers with certain properties are being widely used. These are semiconducting, metallic, dielectric or other layers which are deposited under atmospheric or sub-atmospheric conditions. Amongst others, CVD (chemical vapour deposition), PECVD (plasma enhanced CVD), PVD (physical vapour deposition) as well as APCVD (atmospheric pressure CVD) are well known. Treatment systems of such kind for sub-atmospheric pressure regimes comprise (at least) a vacuum chamber, inlet(s) for substances (like process and/or deposition gases or liquids) and outlet(s) to remove residuals.

As a result of such deposition processes layers of desired properties, thickness and homogeneity are being deposited on workpieces or substrates; however the interior of said vacuum chamber (also: process or deposition chamber) as well as adjacent regions (like in- and outlets) are being affected by (here) unwanted coatings. After deposition of such thin film layers (e. g. silicon layers, nano- or micro-crystalline silicon layers) the deposition chamber must be cleaned, either after each individual run (deposition step or cycle) or after a multitude of deposition runs. It is generally known in the art to use for such cleaning a remote plasma source (RPS). Such RPS generates an active species (here for example fluorine radicals) in a separate chamber, fluidly connected to said process chamber, thus conducting the radicals into the deposition chamber. A uniform gas supply or radical supply into the chamber to be cleaned is required to reach uniform cleaning conditions and thus optimal gas usage and as short as possible cleaning times.

For large-area processing equipment, such as deposition systems for TFT panels, architectural glass and/or photovoltaic cells the problem is more pronounced than for smaller system, like in wafer processing. Generally it has been known to attach an RPS system to the inlet system also used for the deposition and process gases. This way, the cleaning radicals are directed the same way as the gas responsible for the deposition and such the probability is high that all regions where unwanted deposition had taken place are also affected by the cleaning radicals.

### PROBLEMS KNOWN IN THE ART

The conduction of active species into the deposition chamber is in large area deposition equipment linked to significant loss of active species due to volume and surface recombination. The often used gas shower distribution systems comprise piping of considerable length, which means the time between generation of radicals in the RPS until the area to be cleaned is reached, is significant. In semi-conductor equipment where much smaller samples (wafer with 30cm diameter maximum) were prepared the relevant distances are much shorter, therefore this problem has seldom be addressed in the semiconductor/wafer industry.

The radical supply into the large area chamber must be optimized for a large area reactor in order to assure a homogenous and fast cleaning. The pressure gradient between RPS device and the chamber to be cleaned needs to be addressed in large area equipment as well. A non negligible pressure gradient occurs due to the length of the tubes (piping) which influences the optimal parameter space of operation of the RPS itself and the chamber to be cleaned. A separate optimization of parameters in the RPS and in the deposition chamber was therefore never addressed since in these small chambers both parameter spaces are closely linked and not separable. US 7,037,376 to Harvey addresses the problem by directing a cleaning gas from a remote plasma source via the fore-vacuum line into the chamber and via the gas distribution showerhead into an exhaust.

Document EP 1 489 646 A1 discloses a CVD apparatus and method of cleaning the CVD apparatus, comprising a reaction chamber maintained at a vacuum state by exhaust means with inlets and outlets. Two remote plasma sources are connected to the reaction chamber. The apparatus further comprises an exhaust gas recycling path in order to recycle the cleaning gas back to the chamber from the exhaust means. Switching valves are provided in order to provide cleaning or film forming gases.

### BRIEF DESCRIPTION OF THE DRAWINGS

Fig. 1 shows an example of the invention with one RPS and two exhaust means 12, 13.
Fig. 2 shows an embodiment according to the invention, wherein two RPS sources are being used with valves 7, 8, 9, 10.
Fig. 3 shows an embodiment similar to Fig. 2 with still two outlets, two RPS, but one common exhaust pump.

### SUMMARY OF THE INVENTION

One example of the present invention comprises a vacuum chamber, process or deposition chamber or reactor 1 with an inlet 14 and at least two outlets 3, 4. A first of said outlets comprises a connection point for an RPS. A second outlet comprises exhaust means such as a vacuum pump 13. A method for remote plasma cleaning comprises directing a flow of radicals, generated by a remote plasma source attached at a connecting point to the first (reference number 3) of at least two outlets of a vacuum chamber 1 whilst operating exhaust means 13 via the second (reference number 4) of said outlets.

### DETAILED DESCRIPTION OF THE INVENTION

The invention comprises feeding a gas for cleaning (NF₃, C₂F₆, CF₄, CHF₃, F₂, HF, Cl2, HCl, or any other Fluorine or Chlorine comprising precursor) via the first of at least two pumping tubes or outlets 3, 4 into said vacuum chamber.

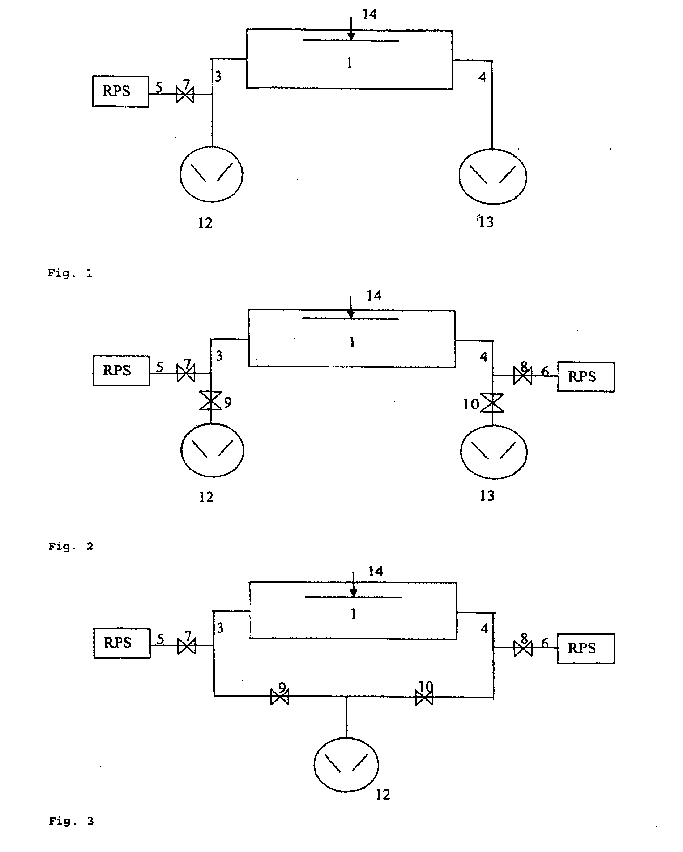

The geometry of the connecting tubing 5, 6 from the external RPS chamber to vacuum chamber (deposition chamber) 1 or connecting point to the outlet(s) 3, 4 must be optimized in diameter (between 0.5 cm and 50 cm), length (between 0.25 m and 50 m, depending on available space), shape and material to minimize the flow resistance. This can be done for example via a particular distribution of diaphragm with cross sections of at least 0.5 mm diameter, bellows, corners (the angle between the two lines are between 0° and 90°), etc. Fig. 1 shows an embodiment of the invention as described above with two outlets 3, 4 and one RPS connected to outlet 3.

Since the pump lines (outlets 3, 4 with exhaust means 12, 13) will be used for normal pumping during deposition a contamination of the RPS system must be avoided. This can be achieved by installing a barrier against deposition gases in connecting tubing (5) between external RPS and deposition chamber 1. This could be for example a valve with tightness between 50% and 100% (feature 7 in Fig. 1 and 7, 8 in Fig. 2) and/or a low flow of purge gas in the direction from the RPS into the chamber, the purge flow per unit perpendicular tube surface (tube cross section) being at least 20 sccm/cm2. Such purge gas may e. g. an inert gas like Ar.

A homogeneous distribution of cleaning radicals can be achieved by installing distribution plates or grids with transparency between 25% and 99%. However it must be noted that these grids must be simultaneously optimized for deposition as well as for cleaning gas distribution.

Preferably a separate optimization of pressure regimes is provided for in a way that the pressure in the RPS is between 0.5 mbar and 25 mbar, whereas the pressure in the vacuum chamber (reactor) is between 0.1 mbar and 10 mbar. This can be achieved for example via modifying the tube geometry, varying the total gas flow, using admixture of rare gases (for example He or Ar), which leads to acceleration of gas flow and changed pressure gradient or multi-step recipes.

A combination of RPS cleaning with standard in situ (power density between 0.02 W/cm² and 0.5 W/cm²) cleaning - called hybrid-cleaning - optimizes cleaning of the main plasma chamber and cleaning in the vacuum gap of a dielectric compensating layer, if present. This can be achieved e. g. in a plasma deposition chamber of the well known parallel plate reactor type.

In a reactor with more than one pump lines from more than one side of the deposition chamber more than one RPS inlets can be used. Fig. 2 shows such an embodiment with 2 RPS sources connected via tubing 5, 6 to the outlets 3, 4.

If more than one RPS inlets into the deposition chamber will be installed (as shown in Fig. 2 & 3) a temporal switching scheme will be used, with switching frequency between 0.001 Hz and 0.5 Hz and duty cycle between 10% and 50% for optimizing the cleaning homogeneity and therefore the cleaning time.

The switching scheme includes valves 9, 10 for alternating blocking one of the pumping lines in order to increase the cleaning efficiency through the other line. With reference to Fig. 2, both pumps 12, 13 are operative during a cleaning cycle. When valve 9 closes, cleaning gas from the RPS connected to outlet 3 will become effective for reactor 1 and exhausting will take place via outlet 4 and pump 13. Depending on the switching cycle, valve 10 will close while valve 9 opens, which results in cleaning gas from the RPS connected to outlet 4 becomes effective for reactor 1. In the embodiment of Fig. 3 a single pump is being used, the principle however remains the same.

### FURTHER ADVANTAGES OF THE INVENTION

It is known to design vacuum deposition systems such that the outlets connected to pumps do not exhibit too much flow resistance, because increased resistance immediately results in prolonged pumping times and reduced pumping efficiency. Therefore those pumping lines will typically be optimized anyway. The invention now uses those optimized outlets and pumping lines in reverse mode to flow in cleaning gases in short times in the reaction chamber, therby increasing the cleaning efficiency considerably.

Thus the use of an RPS according to the invention can help decoupling the deposition and cleaning process. Without any RPS for the so called in-situ cleaning all RF-components must be optimized for two applications, optimal deposition and optimal cleaning. This optimization of RF- and chamber components is complicated, expansive and sometimes requires suboptimal compromises. By installing a RPS the RF-matchbox, the RF-feeding ribbon, the backfilling gas which is linked to lifetime and corrosion prevention can be improved significantly and specifically designed for the deposition cycle.

## Claims

1. A vacuum processing system comprising a vacuum chamber (1) with an inlet (14), at least a first and second outlets (3, 4), exhaust means (13) connected via pumping lines at said outlets (3, 4) and a first and a second remote plasma sources RPS connected via tubing (5, 6) to the outlets (3,4), **characterized by** further including valves (9, 10) configured to alternating blocking one of the pumping lines according to a temporal switching scheme.

2. A vacuum processing system according to claim 1, wherein barrier valves (7, 8) against deposition gases are installed in connecting tubing (5, 6) between external RPS and vacuum chamber (1).

3. A method for remote plasma cleaning of a vacuum processing system with a vacuum chamber (1), at least a first and second outlets (3, 4), a first and second remote plasma sources RPS connected via tubing (5, 6) to the outlets (3, 4), and exhaust means (13) connected via pumping lines at said outlets (3, 4), said method comprising
- Generating a flow of radicals by said remote plasma sources
- directing said flow to said outlets
- Operating the exhaust means during a cleaning cycle
**characterized in that**
a temporal switching scheme is being used for further valves (9, 10), said switching scheme alternating blocking one of the pumping lines thus increasing the cleaning efficiency through the other pumping line.

4. A method according to claim 3, wherein the radicals are generated from one of cleaning gases NF₃, C₂F₆, CF₄, CHF₃, F₂, HF, C12, HCl, or any other Fluorine or Chlorine comprising precursor.

5. A method according to any of claims 3-4, wherein the RPS is operated at a pressure between 0.5mbar and 35mbar and the vacuum chamber is being kept between 0.1mbar and 10mbar.

6. A method according to any of claims 3-5, wherein rare gases are admixed to the flow of radicals.

7. A method according to any of claims 3-6, wherein in a parallel plate reactor additionally a standard in situ cleaning with a power density between 0.02 W/cm² and 0.5 W/cm² is performed.

8. A method according to any of claims 3-7, wherein said temporal switching scheme employs a switching frequency between 0.001Hz and 0.5Hz and a duty cycle between 10% and 50%.

9. A method of deposition in a vacuum processing system and cleaning said vacuum processing system according to any of claims 3-8, wherein during deposition a flow of inert purge gas from the RPS into vacuum chamber (1) is provided for.

10. A method according to claim 9, wherein the flow per unit tube cross section is at least 20 sccm/cm².

## Patentansprüche

1. Vakuum-Prozesssystem, umfassend:
eine Vakuumkammer (1) mit einem Einlass (14), und mindestens einem ersten und einem zweiten Auslass (3, 4),
eine Ausströmeinrichtung (13), die über Pumpleitungen mit den Auslässen (3, 4) verbunden ist, und
eine erste und eine zweite Fernplasmaquelle, RPS, die über Rohre (5, 6) mit den Auslässen (3, 4) verbunden sind,
**gekennzeichnet durch**
Ventile (9, 10), die dazu eingerichtet sind, eine der Pumpleitungen alternierend gemäß einem zeitlichen Schaltschema zu sperren.

2. Vakuum-Prozesssystem nach Anspruch 1, bei dem in Verbindungsrohren (5, 6) zwischen den äußeren Fernplasmaquellen und der Vakuumkammer (1) Sperrventile (7, 8) gegen Abscheidungsgase installiert sind.

3. Verfahren zur Fernplasmareinigung eines Vakuum-Prozesssystems mit einer Vakuumkammer (1), mit mindestens einem ersten und einem zweiten Auslass (3, 4), mit einer ersten und einer zweiten Fernplasmaquelle, RPS, die über Rohre (5, 6) mit den Auslässen (3, 4) verbunden sind, und mit einer Ausströmeinrichtung (13), die über Pumpleitungen mit den Auslässen (3, 4) verbunden ist, wobei das Verfahren folgende Schritte umfasst:
- Erzeugen eines Stroms von Radikalen durch die Fernplasmaquellen,
- Leiten des Stroms an die Auslässe,
- Betreiben der Ausströmeinrichtung während eines Reinigungszyklus, **gekennzeichnet durch**
Verwenden eines zeitlichen Schaltschemas für Ventile (9, 10), wobei das Schaltschema eine der Pumpleitungen derart alternierend sperrt, dass die Reinigungseffizienz **durch** die andere Pumpleitung erhöht wird.

4. Verfahren nach Anspruch 3, bei dem die Radikale aus einem der Reinigungsgase NF₃, C₂F₆, CF₄, CHF₃, F₂, HF, Cl₂, HCl, oder einem andern Präkursor mit Fluor oder Chlor erzeugt werden.

5. Verfahren nach einem der Ansprüche 3 bis 4, bei dem die Fernplasmaquelle bei einem Druck zwischen 0,5 mbar und 35 mbar betrieben wird und die Vakuumkammer zwischen 0,1 mbar und 10 mbar gehalten wird.

6. Verfahren nach einem der Ansprüche 3 bis 5, bei welchem dem Radikalstrom Edelgase zugemischt sind.

7. Verfahren nach einem der Ansprüche 3 bis 6, bei dem in einem Parallelplattenreaktor zusätzlich eine Standard-In-Situ-Reinigung mit einer Leistungsdichte zwischen 0,02 W/cm² und 0,5 W/cm² ausgeführt wird.

8. Verfahren nach einem der Ansprüche 3 bis 7, bei dem für das zeitliche Schaltschema eine Schaltfrequenz zwischen 0,001 Hz und 0,5 Hz und ein Tastverhältnis zwischen 10% und 50% verwendet werden.

9. Verfahren zur Abscheidung in einem Vakuum-Prozesssystem und zur Reinigung des Vakuum-Prozesssystems nach einem der Ansprüche 3 bis 8, wobei während der Abscheidung ein Strom eines Spül-Edelgases von der Fernplasmaquelle in die Vakuumquelle (1) bereitgestellt wird.

10. Verfahren nach Anspruch 9, bei dem der Strom pro Querschnittseinheit des Rohres mindestens 20 sccm/cm² beträgt.

## Revendications

1. Système de traitement sous vide comprenant une chambre à vide (1) ayant une entrée (14), au moins des première et seconde sorties (3, 4), des moyens d'échappement (13) reliés par des conduites de pompage au niveau desdites sorties (3, 4) et une première et une seconde sources de plasma SPD distantes reliées par tubulures (5, 6) aux sorties (3, 4), **caractérisé en ce qu'**il comporte en outre des vannes (9, 10) configurées pour bloquer alternativement l'une des conduites de pompage selon le schéma de commutation temporel.

2. Système de traitement sous vide selon la revendication 1, dans lequel des vannes barrières (7, 8) contre les gaz de dépôt sont installées dans la tubulure de liaison (5, 6) entre la SPD externe et la chambre à vide (1).

3. Procédé de nettoyage par plasma à distance d'un système de traitement sous vide ayant une chambre à vide (1), au moins des première et seconde sorties (3, 4), une première et une seconde sources de plasma distantes SPD reliées par tubulures (5, 6) aux sorties (3, 4), et des moyens d'échappement (13) reliés par des conduites de pompage au niveau desdites sorties (3, 4), ledit procédé comprenant
- la génération d'un flux de radicaux par lesdites sources de plasma distantes,
- l'orientation dudit flux vers lesdites sorties,
- le fonctionnement des moyens d'échappement au cours d'un cycle de nettoyage,
**caractérisé en ce que**
un schéma de commutation temporel est utilisé pour d'autres vannes (9, 10), ledit schéma de commutation bloquant en alternance l'une des conduites de pompage, augmentant de ce fait l'efficacité de nettoyage à travers l'autre conduite de pompage.

4. Procédé selon la revendication 3, dans lequel les radicaux sont générés à partir d'un des gaz de nettoyage NF₃, C₂F₆, CF₄, CHF₃, F₂, HF, C12, HCl, ou de tout autre précurseur comprenant du fluor ou du chlore.

5. Procédé selon l'une quelconque des revendications 3 et 4, dans lequel la SPD est actionnée à une pression entre 0,5 mbar et 35 mbar et la chambre à vide est maintenue entre 0,1 mbar et 10 mbar.

6. Procédé selon l'une quelconque des revendications 3 à 5, dans lequel des gaz rares sont mélangés au flux de radicaux.

7. Procédé selon l'une quelconque des revendications 3 à 6, dans lequel, dans un réacteur à plaques parallèles, en plus, un nettoyage in situ standard est réalisé avec une densité de puissance surfacique entre 0,02 W/cm² et 0,5 W/cm².

8. Procédé selon l'une quelconque des revendications 3 à 7, dans lequel ledit schéma de commutation temporel utilise une fréquence de commutation entre 0,001 Hz et 0,5 Hz et un cycle de service entre 10 % et 50 %.

9. Procédé de dépôt dans un système de traitement sous vide et de nettoyage dudit système de traitement sous vide selon l'une quelconque des revendications 3 à 8, dans lequel, lors du dépôt, un flux de gaz de purge inerte provenant de la SPD est fourni à la chambre à vide (1).

10. Procédé selon la revendication 9, dans lequel le débit par section transversale de tube unitaire est d'au moins 20 cm³/min/cm².
